(19) Europäisches Patentamt
European Patent Office
Office européen des brevets

(11) **EP 3 098 248 A1**

(12) **EUROPÄISCHE PATENTANMELDUNG**

(43) Veröffentlichungstag:
**30.11.2016 Patentblatt 2016/48**

(51) Int Cl.:
*C08G 18/78* (2006.01)        *C08G 18/42* (2006.01)
*C08G 18/48* (2006.01)        *C08G 18/71* (2006.01)
*C08G 18/28* (2006.01)        *C08G 18/50* (2006.01)
*C08J 5/18* (2006.01)        *H01L 41/00* (2013.01)

(21) Anmeldenummer: **15169903.0**

(22) Anmeldetag: **29.05.2015**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA**

(71) Anmelder:
• **Covestro Deutschland AG**
  **51373 Leverkusen (DE)**
• **Fraunhofer-Gesellschaft zur Förderung der angewandten Forschung e.V.**
  **80686 München (DE)**

(72) Erfinder:
• **Krause, Jens**
  **51375 Leverkusen (DE)**
• **Wagner, Joachim**
  **51061 Köln (DE)**
• **Krüger, Hartmut**
  **12163 Berlin (DE)**
• **Wieland, Franziska**
  **14471 Potsdam (DE)**

(74) Vertreter: **Levpat**
  **c/o Covestro AG**
  **Gebäude 4825**
  **51365 Leverkusen (DE)**

(54) **POLYMERES, NICHT ANGEBUNDENES ADDITIV ZUR ERHÖHUNG DER DIELEKTRIZITÄTSKONSTANTE IN ELEKTROAKTIVEN POLYURETHAN POLYMEREN**

(57)    Die Erfindung betrifft ein Verfahren zur Herstellung eines dielektrischen Polyurethan-Polymers durch Umsetzung einer Mischung umfassend:

a) eine Isocyanat-Gruppen enthaltenden Verbindung mit einer zahlenmittleren Isocyanat-Funktionalität von $\geq 2{,}3$ und $\leq 6$;

b) eine Isocyanat-reaktive Gruppen enthaltenden Verbindung mit einer zahlenmittleren Funktionalität an Isocyanat-reaktiven Gruppen von $\geq 1{,}5$ und $\leq 6$;

c) einem polymeren Additiv erhältlich durch stöchiometrische Umsetzung

c1) eines Monoisocyanats der allgemeinen Formel Ia und / oder Ib

$$\text{NCO-X-(A)n} \qquad \text{(Formel Ia)}$$
$$\text{NCS-X-(A)n} \qquad \text{(Formel Ib)}$$

mit

c2) einer Polyolkomponente mit einem zahlenmittlerem Molgewicht Mn von 100 bis 1500 g/mol und einer Funktionalität von 2 bis 4;

d) optional einen Katalysator;

wobei

X ein organischer Rest mit einem delokalisierten Elektronensystem, A eine Elektronenakzeptorfunktionalität, ausgewählt aus der Gruppe bestehend aus $-NO_2$, $-CN$, $-F$, $-Cl$, $-CF_3$, $-OCF_3$, Cyanovinyl-, Dicyanovinyl- oder Tricyanovinyl-Resten und n eine Ganze Zahl von 1 bis 3 ist. Die Erfindung betrifft ferner ein nach dem Verfahren erzeugtes dielektrisches Polyurethan-Polymer sowie dessen Verwendung.

EP 3 098 248 A1

**Beschreibung**

Die vorliegende Erfindung betrifft ein Verfahren zur Herstellung eines dielektrischen Polyurethan-Polymers, ein nach dem Verfahren hergestelltes dielektrisches Polyurethan-Polymer, sowie dessen Verwendung alleine oder als Blend als Dielektrikum, als elastisches Dielektrikum, als Aktuator, als künstlicher Muskel, als Dielektrikum für flexible elektronische Bauteile, insbesondere Kondensatoren.

In an sich bekannten elektromechanischen Wandlern wird elektrische in mechanische Energie umgewandelt und umgekehrt. Sie können als Bestandteil von Sensoren, Aktoren und/oder Generatoren eingesetzt werden.

Derartige Wandler bestehen typischerweise aus elektroaktiven Polymeren (EAP). Das Aufbauprinzip und die Wirkungsweise sind dem eines elektrischen Kondensators ähnlich. Es gibt ein Dielektrikum zwischen zwei Platten unter Spannung. Allerdings handelt es sich bei EAPs um ein deformierbares Dielektrikum, welches sich im elektrischen Feld verformt. Genau genommen sind es dielektrische Elastomere meist in Folienform (DEAP; dielektrisches elektroaktives Polymer), welche einen hohen elektrischen Widerstand haben und beidseitig mit dehnbaren Elektroden hoher Leitfähigkeit beschichtet sind (Elektrode), wie beispielsweise in WO-A 01/06575 beschrieben. Dieser grundsätzliche Aufbau kann in unterschiedlichsten Konfigurationen zur Herstellung von Sensoren, Aktoren oder Generatoren eingesetzt werden. Neben einschichtigen Aufbauten sind auch mehrschichtige Aufbauten bekannt.

Gemeinsame mechanische Eigenschaften sind eine ausreichend hohe Bruchdehnung, niedrige bleibende Dehnungen und ausreichend hohe Druck-/Zug-Festigkeiten. Diese Eigenschaften sorgen für eine ausreichend große elastische Deformierbarkeit ohne mechanische Beschädigung des Energiewandlers. Für Energiewandler, die in Zug betrieben werden ist es besonders wichtig, dass diese Elastomere keine bleibende Dehnung aufweisen und unter mechanischer Last keine Spannungsrelaxation zeigen. Mit anderen Worten sollte ein Fließen, der so genannte "creep",nicht auftreten, da sonst nach einer bestimmten Zyklenzahl an Dehnungen kein EAP Effekt mehr vorhanden ist.

Es gibt aber auch je nach Anwendung divergierende Anforderungen: Für Aktoren im Zug-Modus werden hochreversibel dehnbare Elastomere mit hoher Bruchdehnung und niedrigem Zug-E-Modul benötigt. Für Generatoren, die in Dehnung betrieben werden, ist dagegen ein hoher Zug-E-Modul sinnvoll. Auch die Anforderungen an den Innenwiderstand sind unterschiedlich; für Generatoren werden deutlich höhere Anforderungen an den Innenwiderstand gestellt als für Aktoren.

Aus der Literatur ist für Aktoren bekannt, dass die Dehnbarkeit zur Dielektrizitätskonstante und der angelegten Spannung zum Quadrat sowie umgekehrt proportional zum Modul ist. Dieser Zusammenhang aus der relativen Dielektrizitätskonstante $\varepsilon_r$ der absoluten Dielektrizitätskonstante $\varepsilon_0$ , dem Modul $Y$, der Foliendicke $d$ und der Schaltspannung $U$ mit der Dehnung $s_z$ ergibt sich aus der folgenden Gleichung 1

$$ s_z = \frac{\sigma_{Maxwell}}{Y} = \frac{\varepsilon_0 \cdot \varepsilon_r}{Y} \left( \frac{U}{d} \right)^2 $$

(Gleichung 1)

Die Dielektrizitätskonstanten und die Elektrische Feldstärke können dabei zum sogenannten MAXWELL-Druck $\sigma_{Maxwell}$ zusammengefast werden. Die Spannung ist wiederum an die Durchbruchfeldstärke in der Weise gekoppelt, dass bei sehr niedriger Durchbruchbruchfeldstärke keine hohe Spannung angelegt werden kann. Da dieser Wert quadratisch in die Gleichung zur Berechnung der Dehnung eingeht, welche durch die elektromechanische Anziehung der Elektroden hervorgerufen wird, muss die Durchbruchfeldstärke entsprechend hoch sein. Eine typische Gleichung hierzu findet man in dem Buch von Federico Carpi, Dielectric Elastomers as Electromechanical Transducers, Elsevier, Seite 314, Gleichung 30.1 sowie ähnlich auch in R. Pelrine, Science 287, 5454, 2000, Seite 837, Gleichung 2. Bis jetzt bekannte Aktoren sind entweder in der Dielektrizitätskonstante und/oder der Durchbruchfeldstärke zu niedrig oder im Modul zu hoch. Nachteilig an bekannten Lösungen ist auch der niedrige elektrische Widerstand, der bei Aktoren zu hohen Leckströmen und im schlimmsten Fall zu einem elektrischen Durchschlag führt.

Für Generatoren ist wichtig, dass sie eine hohe elektrische Stromausbeute bei niedrigen Verlusten besitzen. Typische Verluste entstehen an Grenzflächen, beim Be- und Entladen des dielektrischen Elastomers sowie durch Leckströme durch das dielektrische Elastomer. Zusätzlich bewirkt der Widerstand der elektrisch leitfähigen Elektrodenschicht des EAPs einen Energieverlust. Die Elektrode sollte daher wiederum einen möglichst geringen elektrischen Innenwiderstand haben. Eine Beschreibung findet sich in einem Artikel von Christian Graf und Jürgen Maas, Energy harvesting cycles based on electro active polymers, proceedings of SPIE Smart structures, 2010, vol. 7642, 764217. Aus den Herleitungen gemäß Gleichung 34 und 35, folgt auf Seite 9 (12) letzter Satz, dass der Energieverlust minimal ist, wenn die Dielektrizitätskonstante sowie der elektrische Widerstand besonders hoch sind.

Da nahezu alle elektroaktiven Polymere unter zyklischen Belastungen und vorgedehnten Strukturen betrieben werden, dürfen die Materialien bei wiederholten zyklischen Belastungen nicht zum Fließen neigen und der "creep" sollte daher so gering wie möglich sein.

Die Permittivität heutiger Elastomere ist jedoch in der Regel auf Werte von bis zu 6 beschränkt. Dadurch ergeben sich für aus diesen Materialien gefertigten künstlichen Muskeln und Aktorikelementen Schaltspannungen von in der Regel > 1 kV. Diese hohen Schaltspannungen setzen der Anwendbarkeit dieser Technologie enge Grenzen. Daher sind verschiedene technische Vorschläge und Lösungen unterbreitet worden, die zu einer deutlichen Anhebung der Permittivität führen. So kann durch Blenden der genannten Polymere mit Nanopartikeln hochpermittiver anorganischer Materialien, wie Bariumtitanat, Bleizirkonat, Titandioxid u.a., die Permittivität der Elastomere deutlich erhöht werden, so dass niedrigere Schaltspannungen von einigen hundert Volt erreicht werden könnten. Diese Lösungen beinhalten jedoch deutliche Nachteile, die in einer wesentlichen Verschlechterung der Verarbeitungseigenschaften, in einer Veränderung der mechanischen Eigenschaften der Elastomere (Versteifung) und in Problemen der homogenen Verteilung der Nanopartikel in der Elastomermatrix liegen. Nanopartikel können aggregieren, agglomerieren und zu Problemen bei der Bildung homogener Elastomerfilme führen. Weiterhin sind Nanopartikel der genannten anorganischen Materialien durch ihre hohe innere Oberfläche in der Regel hochreaktiv und können somit zu einer Destrukturierung oder einer Schädigung der Elastomermatrix führen. Weiterhin stellen die Wechselwirkungen an der Grenzfläche Nanopartikel/Elastomermatrix ein häufiges, nicht einfach zu lösendes Problem bei der Anwendung von Nanopartikeln zur Erhöhung der Permittivität von dielektrischen Elastomeren dar.

Es wurde ferner der Versuch unternommen, existierende Elastomere durch das Hinzufügen von weiteren Komponenten, wie Füllpartikeln, zu modifizieren. Hierfür wurden elektrisch nicht leitfähige und leitfähige Partikel benutzt. Der Vorteil der Einfachheit der Modifizierung von bereits existierenden Elastomeren hat zu vielen unterschiedlichen Herangehensweisen in der Materialforschung geführt.

Als keramische, dielektrische Partikel können TiO2, BaTiO3, PMN-PT (Blei-Magnesium-Niobat mit Bleititanat) oder andere Materialien verwendet werden. Diese Keramiken sind für ihre hohen Permittivitäten bekannt, die typischerweise mehrere Größenordnungen größer sind als die Permittivität des amorphen Elastomers. Das direkte Dispergieren der Partikel hat zu divergierenden Ergebnissen geführt. Es wurden zum Einen Verbesserungen und zum Anderen Verschlechterungen in der maximalen Aktorauslenkung erzielt. Dies ist auf die relativ geringe Erhöhung der Permittivität des Komposits und der gleichzeitigen starken Erhöhung des Elastizitätsmoduls durch die Partikelzugabe zurückzuführen. Zu dem führt das Einmischen der genannten Nanopartikel häufig zu einer deutlichen Absenkung der Durchbruchsfeldstärke, was wiederum enge Grenzen im Betrieb daraus gefertigter Aktoren und Generatoren setzt.

Eine Möglichkeit der Senkung des Elastizitätsmoduls ist die Zugabe von Weichmachern. Die Verwendung von Tensiden führt zu einer verbesserten Dispersion der Partikel und verhindert deren Agglomeration. Somit können auch Partikel mit einem Durchmesser von nur 15 nm verwendet werden. Die schlechte Beschaffenheit der meisten Komposite führte jedoch dazu, dass mögliche Anwendungen dieser Materialien als Aktoren nicht weiter verfolgt wurden.

Die Verwendung elektrisch leitfähiger Partikel ist ebenfalls bekannt (Q. M. Zhang, H. Li, M. Poh, F. Xia, Z.-Y. Cheng, H. Xu, and C. Huang, \An all-organic composite actuator material with a high dielectric constant," Nature 419, pp. 284{287, 2002.). In ersten Versuchen wurden Farbstoffe und leitfähige Polymere verwendet. Eine spätere Veröffentlichung (C. Huang and Q. Zhang, \Fully functionalized high-dielectric-constant nanophase polymers with high electromechanical response," Adv. Mater 17, p. 1153, 2005. Doi: 10.1002/adma.200401161.) ließ Zweifel bezüglich der Permittivitätserhöhung aufkommen. Die Erhöhung der Permittivität in CuPc-PU-Kompositen z.B. war die Folge einer unvollständigen chemischen Reaktion. Eine Arbeit, die auf der zufälligen Verteilung von elektrisch leitfähigen Carbon Black-Partikeln in einem thermoplastischen Elastomer basiert, führte zu einer starken Erhöhung der Permittivität aber auch gleichzeitig zu einer stark verminderten Durchbruchsfeldstärke. In einer anderen Arbeit wurde ein halbleitendes Polymer (Poly(3-hexylthiophen)) mit einem chemisch verlinkenden Silikon vermischt. Daraus resultierte eine Erhöhung der Permittivität sowie eine Verminderung des Elastizitätsmoduls. In allen zuvor erwähnten Fällen wurde neben den erzielten Verbesserungen auch immer die Durchbruchsfeldstärke stark verringert. Dies begrenzt sehr stark die maximale Aktorauslenkung.

In WO 2012/038093 werden Dipol-Moleküle mit einer elektronenziehenden und einer elektronenschiebenden Struktureinheit an ein Polymer gebunden. Solche Dipol-Moleküle werden auch als "push-pull"-Moleküle" bezeichnet. Bei dem hier beschriebenen Verfahren kann es als nachteilig empfunden werden, dass sie die Dipol-Moleküle unkontrolliert in das Polymer eingebaut werden und hierbei die Polymerstruktur negativ beeinflussen können. Die Moleküle wirken als Kettenverlängerer und erhöhen neben dem Modul des Elastomers auch den Glaspunkt was zu duroplastischen nicht elastomeren Polymeren im Falle der Polyurethane führen würde. Gerade bei Polyurethan Elastomeren für elektroaktiven Polymere liegt die Glasübergangstemperatur meist um die Null Grad. Eine weitere Erhöhung führt zu einem Verlassen des Gebrauchstemperaturbereiches, das heißt zu einer Glasübergangstemperatur oberhalb der Raumtemperatur.

Im Stand der Technik sind Wandler beschrieben, welche verschiedene Polyurethane als Bestandteil der elektroaktiven Schicht enthalten, wie beispielsweise in WO 2012/038093 A1.

Nachteilig an Polyurethan-basierten Wandlern ist, dass im Falle der Polyetherpolyol-basierten dielektrischen Polyurethan-Filme der elektrische Widerstand sowie die Durchbruchsfeldstärke zu niedrig sind. Im Falle der Polycarbonatpolyol- und Polyesterpolyol-basierten Wandler liegt die Glasübergangstemperatur bei > 0°C so dass die Wandler nur eingeschränkt bei typischen Umgebungstemperaturen betrieben werden können. Nachteilig ist ferner, dass die Dielektrizitätskonstante bei den vorgenannten Typen sehr niedrig ist, so dass der Wandler bei hoher elektrischen Spannungen betrieben werden muss. Die verwendete Hochspannungselektronik ist jedoch sehr teuer und macht eine breite Nutzung der elektromechanischen Wandler in vielen Anwendungsbereichen unwirtschaftlich.

Der vorliegenden Erfindung lag somit die Aufgabe zugrunde, ein Verfahren zur Herstellung eines dielektrischen Polyurethan-Polymers zur Verfügung zu stellen, das die Erzeugung eines Polymers ermöglicht, das sich gut zu Polymerfolien verarbeiten lässt und das eine hohe Dielektrizitätskonstante bei gleichzeitig niedrigem Elastizitätsmodul aufweisen soll, sodass die Dehnung $s_z$ gemäß der obigen Gleichung 1 verbessert wird.

Die Aufgabe wird gelöst durch ein Verfahren zur Herstellung eines dielektrischen Polyurethan-Polymers durch Umsetzung einer Mischung umfassend:

a) eine Isocyanat-Gruppen enthaltenden Verbindung mit einer zahlenmittleren Isocyanat-Funktionalität von $\geq 2,3$ und $\leq 6$;

b) eine Isocyanat-reaktive Gruppen enthaltenden Verbindung mit einer zahlenmittleren Funktionalität an Isocyanat-reaktiven Gruppen von $\geq 1,5$ und $\leq 6$;

c) einem polymeren Additiv erhältlich durch stöchiometrische Umsetzung

c1) eines Monoisocyanats der allgemeinen Formel Ia und / oder Ib

NCO-X-(A)n          (Formel Ia)

NCS-X-(A)n          (Formel Ib)

mit

c2) einer Polyolkomponente mit einem zahlenmittlerem Molgewicht Mn von 100 bis 1500 g/mol, insbesondere 200 bis 800 g/mol und einer Funktionalität von 2 bis 4;

d) optional einen Katalysator;
wobei
X ein organischer Rest mit einem delokalisierten Elektronensystem, A eine Elektronenakzeptorfunktionalität, ausgewählt aus der Gruppe bestehend aus $-NO_2$, $-CN$, $-F$, $-Cl$, $-CF_3$, $-OCF_3$, Cyanovinyl-, Dicyanovinyl- oder Tricyanovinyl-Resten und n eine Ganze Zahl von 1 bis 3 ist.

Der vorliegenden Erfindung liegt die Erkenntnis zugrunde, dass durch die in-situ Polymerisation eines Polyisocyanats und eines Polyols zu einem Polyurethan in Anwesenheit eines Dipol-modifizierten polymeren Polyurethans ein dielektrisches Polyurethan-Polymer herstellbar ist, dass sich durch eine hohe Dielektrizitätskonstante bei gleichzeitig niedrigem Elastizitätsmodul auszeichnet. Dabei ist das Dipol-modifizierte polymere Polyurethan so ausgestaltet, dass es eine "push-pull"-Fuktionalität besitzt. Das erfindungsgemäße dielektrische Polyurethan-Polymer ist also im einfachsten Falle eine Mischung aus durch Reaktion der Komponenten a) und b) erzeugten Polyurethan und dem polymeren Additiv c).

Die NCO-Funktionalität wird, wenn nicht ausdrücklich anders erwähnt, volumetrisch gemäß DIN EN ISO 11909 bestimmt.

In der Formel (Ia) beziehungsweise (Ib) handelt es sich bei der Gruppe X um einen organischen Rest mit einem delokalisierten Elektronensystem. Ein delokalisiertes Elektronensystem ist beispielsweise ein solches mit einem delokalisierten PI-Elektronensystem. Hierdurch wird eine Delokalisierung der Elektronen zwischen D und A ermöglicht. Typische Vertreter der Gruppe X sind beispielsweise eine Phenylengruppe, eine Naphthylengruppe, konjugierte Aromaten, wie beispielsweise Biphenyle, Stilbene, Azobenzene, Terphenyle, oder analoge hetroaromatische Systeme.

Ein nach dem erfindungsgemäßen Verfahren hergestellter dielektrischer Polyurethan Film weist eine gute mechanische Festigkeit und eine hohe Elastizität auf. Weiterhin hat er gute elektrische Eigenschaften wie eine hohe Durchbruchsfeldstärke, einen hohen elektrischen Widerstand und eine hohe Dielektrizitätskonstante und kann daher vorteilhaft in einem elektromechanischen Wandler mit hohem Wirkungsgrad eingesetzt werden.

Als Polyisocyanatkomponente kann jedes an sich zur Herstellung von Polyurethanen bekannte organische Polyisocyanat eingesetzt werden oder aber auch beliebige Mischungen von organischen Polyisocyanaten. Diese werden im Folgenden noch näher spezifiziert.

Als Isocyanat-reaktive Gruppen enthaltende Verbindung kommen im Prinzip sämtliche zur Polyurethanerzeugung bekannte Verbindungen dieser Art in Betracht. Beispiele hierfür sind organische Verbindungen mit OH-, SH-, $NH_2$- und/oder NHR- Gruppen, wobei R wiederum ein beliebiger organischer Rest sein kann, beispielsweise ein Alkylrest oder dergleichen. Bevorzugt handelt es sich bei den Isocyanat-reaktiven Gruppen der Verbindung b) um Hydroxyl- und / oder Amin-Gruppen, wobei die Isocyanat-reaktive Gruppen enthaltende Verbindung b) insbesondere eine OH-Zahl von ≥10 und ≤150 mg KOH/g besitzt, bevorzugt von ≥27 und ≤150, besonders bevorzugt ≥ 27 und ≤ 120. Die OH-Zahl wird gemäß DIN 53240 bestimmt.

Nach einer Weiterbildung des erfindungsgemäßen Verfahrens wird das polymere Additiv c) in einer Menge von 2 Gew.-% bis 50 Gew.-% bezogen auf die gesamte Mischung zur Herstellung eines dielektrischen Polyurethans eingesetzt, bevorzugt 5 bis 40 Gew.-%.

Die Polyolkomponente c2) ist bevorzugt ausgewählt aus der Gruppe bestehend aus Polyesterpolyolen, Polycarbonatpolyolen und Polyestercarbonatpolyolen. Diese Polyole sind vorteilhaft, da sie durch ihr elektronenreiches Polymer-backbone gute elektrische Leitungseigenschaften in das polymere Additiv einbringen, die sich wiederum positiv auf dessen "push-pull"-Funktionalität auswirken.

In bevorzugter Ausgestaltung des erfindungsgemäßen Verfahrens hat die Polyolkomponente c2) eine OH-Zahl ≥ 112 und ≤ 1400 mg KOH/g, insbesondere > 200 und ≤900.

Bei dem erfindungsgemäßen Verfahren kann in vorteilhafter Weise vorgesehen sein, dass das polymere Additiv c) erhältlich ist durch stöchiometrische Umsetzung von c1), c2) und zumindest einer monofunktionellen Verbindungen c3), wobei die monofunktionelle Verbindung c3) insbesondere ausgewählt ist aus Ethanol, n-Butanol, Ethylenglykolmonobutylether, Diethylenglykolmonomethylether, Diethylenglykolmonobutylether, Propylenglykolmono-methylether, Dipropylenglykol-monomethylether, Tripropylenglykol-monomethylether, Dipropylenglykolmono-propylether, Propylenglykolmonobutylether, Dipropylenglykol-monobutylether, Tripropylenglykolmonobutylether, 2-Ethylhexanol, 1-Octanol, 1-Dodecanol oder 1-Hexadecanol oder Mischungen davon.

Die Isocyanat-reaktive Gruppen enthaltende Verbindung b) und / oder die Polyolkomponente c2) können eine zahlenmittlere OH-Funktionalität von ≥ 1,5 und ≤ 6 aufweisen, insbesondere ≥ 1,5 und ≤ 4,4, bevorzugt ≥ 1,5 und ≤ 3,4, besonders bevorzugt ≥ 1,5 und ≤ 2,8.

Bei dem Erfindungsgemäßen Verfahren kann in der Weise Verfahren werden, dass das dielektrischen Polyurethan-Polymer erhalten wird, indem

- die gesamten Einsatzmengen an a) und b) in Anwesenheit von c) sowie gewünschtenfalls d) oder
- zunächst eine Teilmenge der Isocyanat-Gruppen enthaltenden Verbindung a) mit einer Teilmenge der Isocyanat-reaktive Gruppen enthaltenden Verbindung b) umgesetzt und das dabei erhaltene Präpolymer anschließend mit der Restmenge der Isocyanat-Gruppen enthaltenden Verbindung a) in Anwesenheit von c) sowie gewünschtenfalls d)

umgesetzt wird. Damit wird die Möglichkeit eröffnet, entweder im "one-shot"-Verfahren alle Komponenten unmittelbar zu mischen und miteinander umzusetzen oder zunächst ein Präpolmer herzustellen, welches dann in einem nachgelagerten Schritt mit der Polyisocyanatkomponente (aa) und der restlichen Teilmenge der Polyolkomponente (bb) zur Reaktion gebracht wird. Hierbei kann das so hergestellte Präpolymer direkt weiter verarbeitet oder erst abgefüllt und gelagert werden und später eingesetzt werden.

Unabhängig davon, wie die Komponenten miteinander umgesetzt werden, können die an sich für diese Reaktionen dem Fachmann bekannten Polymerisationskatalysatoren eingesetzt werden, beispielsweise Dibutylzinndilaurat oder dergleichen.

Die Erfindung betrifft weiterhin ein dielektrisches Polyurethan-Polymer erhältlich oder erhalten nach dem erfindungsgemäßen Verfahren. Das dielektrische Polyurethan-Polymer besitzt bevorzugt eine, mehrere oder sämtliche der folgenden Eigenschaften:

a. Einen Zugmodul von < 5 MPa bei 25% Dehnung nach DIN 53 504;

b. eine Bruchdehnung von > 20% nach DIN 53 504, insbesondere > 50%, bevorzugt > 80%;

c. eine Spannungsrelaxation (Creep) gemäß DIN 53 441 bei 10% Deformation nach 30 min nach DIN 53 441 von < 20%, insbesondere < 15%, bevorzugt < 10%;

d. eine Durchbruchfeldstärke von > 40 V/$\mu$m nach ASTM D 149-97a, insbesondere > 60 V/$\mu$m, bevorzugt > 80 V/$\mu$m;

e. einen elektrischen Widerstand von > 1,0 E10 Ohm m nach ASTM D 257, insbesondere > 1,0 E11 Ohm m, bevorzugt > 5,0 E11 Ohm m;

f. eine Dielektrizitätskonstante von > 8 bei 0,01 - 1 Hz nach ASTM D 150-98;

g. eine Knotendichte > 0,13 mol/kg und < 1,5 mol /kg;

h. eine Energiedichte > 0,2 J/cm$^3$;

i. eine Dielektrizitätskonstante nach ASTM D 150-98 bei 1 Hz von wenigstens 8, insbesondere von 8 bis 15;

j. eine elektrische Durchschlagfestigkeit von wenigstens 80 V/$\mu$m nach ASTM D 149-97a, insbesondere von 80 bis 230;

k. einen elektrischen Volumenwiderstand von wenigstens 1 E11 V/cm nach ASTM D 257, insbesondere von 1,0 E11 V/cm bis 8,0 E16 V/cm;

l. einen Creep gemäß DIN 53 441 von wenigstens 12%, insbesondere von 0.15 bis 12.

Unter der "Knotendichte" des dielektrischen Polyurethan-Polymers (Einheit: [mol/kg]) wird die Anzahl der dreiwertigen, permanenten chemischen Vernetzungsstellen des Polyurethanelastomeren in Mole pro Kilogramm Polyurethan-Polymer verstanden. Hierzu werden die Stoffmengen aller Moleküle der Ausgangsrohstoffe des Polyurethan-Polymers mit einer höheren Funktionalität als 2 erfasst. Um alle Vernetzungsstellen wie trifunktionelle Vernetzungsstellen behandeln zu können, werden die Funktionalitäten höherfunktioneller Molekülsorten unterschiedlich gewichtet: trifunktionelle Moleküle werden mit 1 gewichtet, tetrafunktionelle mit 2, pentafunktionelle mit 3, hexafunktionelle mit 4 u.s.w. Nach dieser Definition hätte ein Polyurethan aus den äquivalent verschäumten Komponenten Polyesterdiol, 1,4-Butandiol, Triethanolamin, Pentaerythrit mit einem Gemisch aus 1,21 Gew.-% 2,4'-Diphenylmethandiisocyanat und 98,79 Gew.% 4,4'-Diphenyl-methandiisocyanat eine Knotendichte von 0,69 mol/kg. Zur Berechnung wird auch auf EP 1 556 429 B1 verwiesen, insbesondere auf den Abschnitt [0017].

Ferner kann vorgesehen sein, die Permittivität der Polyurethan-Polymere durch geeignete Additive weiter zu steigern. Diese Additive können unter bestimmten Umständen und bei geeigneter Struktur nicht zu einer Versteifung der Polyurethane führen, da sie eher eine weichmachende Wirkung erzeugen. An geeignete Additive werden bestimmte Voraussetzungen unter zusätzlicher Beachtung der folgenden Zielstellungen gestellt:

1. Das Additiv zur Erhöhung der Dielektrizitätskonstante soll verträglich mit dem Polyurethan sein,
2. polymer sein, um eine Migration auszuschließen,
3. den elektrischen Widerstand sowie die elektrische Spannungsfestigkeit nicht negativ beeinflussen,
4. die Polyurethanreaktion nicht negativ beeinflussen und
5. die Anwendung der üblichen Filmbildungsverfahren ermöglichen.

Die vorgenannten Voraussetzungen erfüllende Additive sind beispielsweise ausgewählt aus keramischen Füllstoffen, insbesondere Bariumtitanat, Strontiumtitanat, Kupfertitanat, Calciumtitanat, Titandioxid und piezoelektrische Keramiken wie Quarz oder Bleizirkoniumtitanat, und Mischoxide aller oben erwähnten Verbindungen sowie organische Füllstoffe, insbesondere solche mit einer hohen elektrischen Polarisierbarkeit, beispielsweise Phthalocyanine, Poly-3-Hexylthiophen. Typische Einsatzmengen liegen bei bis zu 1 Gew.-% bezogen auf das dielektrische Polyurethan-Polymer.

Außerdem ist eine höhere Dielektrizitätskonstante auch durch das Einbringen elektrisch leitfähiger Füllstoffe unterhalb der Perkolationsschwelle erzielbar. Beispiele für derartige Stoffe sind außer Metalle wie z.B. Silber, Aluminium und Kupfer, Ruß, Graphit, Graphen, Fasern, einwandige oder mehrwandige Kohlenstoff-Nanoröhrchen, elektrisch leitfähige Polymere wie Polythiophene, Polyaniline oder Polypyrrole, oder Mischungen davon. In diesem Zusammenhang sind insbesondere solche Rußtypen von Interesse, die eine Oberflächenpassivierung aufweisen und deshalb bei niedrigen Konzentrationen unterhalb der Perkolationsschwelle zwar die Dielektrizitätskonstante erhöhen und trotzdem nicht zu einer Erhöhung der Leitfähigkeit des Polymers führen. Hier sind solche Rußtypen mit besonders hoher BET-Oberfläche bevorzugt.

Im Rahmen der vorliegenden Erfindung können Additive zur Erhöhung der Dielektrizitätskonstanten und / oder der elektrischen Durchschlagsfeldstärke auch noch nach der Verfilmung von Polyurethanen zugesetzt werden. Dies kann beispielsweise durch Erzeugung einer oder mehrerer weiterer Schichten oder durch Durchdringung des Polyurethan-Films beispielsweise durch Eindiffundieren erfolgen.

Ein weiterer Gegenstand der vorliegenden Erfindung betrifft die Verwendung eines erfindungsgemäßen dielektrischen Polyurethan-Polymers oder eines Blends aus diesem dielektrischen Polyurethan-Polymer und wenigstens einem weiteren Polymer ausgewählt aus der Gruppe bestehend aus Elastomeren, insbesondere linearen oder vernetzten Polyalkylsiloxanen, linearen oder vernetzten partiell wasserstofffunktionalisierten Polysiloxanen, Polyurethanen, Polybutadienkautschuken und/oder Poly(meth)acrylaten, als Dielektrikum, als elastisches Dielektrikum, als Aktuator, als künstlicher Muskel, als Dielektrikum für flexible elektronische Bauteile, insbesondere Kondensatoren, insbesondere weiche Kondensatoren.

Die Erfindung betrifft zudem einen Formkörper in Form eines Dielektrikums, eines künstlichen Muskels und/oder eines Aktuators, wie vorgestreckte Aktuatoren und/oder Stapelaktuatoren, wobei der Formkörper ein erfindungsgemäßes dielektrisches Polyurethan-Polymer oder ein Blend aus diesem erfindungsgemäßen dielektrischen Polyurethan-Polymer und wenigstens einem weiteren Polymer enthält, wobei das weitere Polymer ausgewählt ist aus der Gruppe bestehend aus Elastomeren, insbesondere linearen oder vernetzten Polyalkylsiloxanen, linearen oder vernetzten partiell wasserstofffunktionalisierten Polysiloxanen, Polyurethanen, Polybutadienkautschuken und/oder Poly(meth)acrylaten.

Ein weiterer Gegenstand der vorliegenden Erfindung ist ein elektrochemischer Wandler, enthaltend ein erfindungsgemäßes dielektrisches Polyurethan-Polymer oder oder ein Blend aus diesem erfindungsgemäßen dielektrischen Polyurethan-Polymer und wenigstens einem weiteren Polymer enthält, wobei das weitere Polymer ausgewählt ist aus der Gruppe bestehend aus Elastomeren, insbesondere linearen oder vernetzten Polyalkylsiloxanen, linearen oder vernetzten partiell wasserstofffunktionalisierten Polysiloxanen, Polyurethanen, Polybutadienkautschuken und/oder Poly(meth)acrylaten.

Bei einem elektromechanischen Wandler ist die Elektrodenschicht auf den Lagen vorzugsweise so aufgebracht, dass sie von den Seiten kontaktiert werden kann und nicht über dem dielektrischen Filmrand steht, da es sonst zu Durchschlägen kommt. Gängigerweise lässt man hier zwischen Elektrode und Dielektrikum einen Sicherheitsrand, so dass die Elektrodenfläche kleiner als die Dielektrikumsfläche ist. Die Elektrode ist so strukturiert, dass eine Leiterbahn zur elektrischen Kontaktierung heraus geführt wird.

Der Wandler kann vorteilhaft in unterschiedlichsten Konfigurationen zur Herstellung von Sensoren, Aktoren und/oder Generatoren eingesetzt werden. Ein weiterer Gegenstand der vorliegenden Erfindung ist daher eine elektronische und/oder elektrische Vorrichtung, insbesondere ein Baustein, Automat, Instrument oder eine Komponente, umfassend einen erfindungsgemäßen elektromechanischen Wandler.

Ferner betrifft die vorliegende Erfindung die Verwendung eines erfindungsgemäßen elektromechanischen Wandlers in einer elektronischen und/oder elektrischen Vorrichtung, insbesondere in einem Aktor, Sensor oder Generator. Vorteilhafterweise kann die Erfindung in einer Vielzahl von verschiedensten Anwendungen im elektromechanischen und elektroakustischen Bereich, insbesondere im Bereich der Energiegewinnung aus mechanischen Schwingungen (Energy-Harvesting), der Akustik, des Ultraschalls, der medizinischen Diagnostik, der akustischen Mikroskopie, der mechanischen Sensorik, insbesondere Druck- Kraft- und/oder Dehnungssensorik, der Robotik und/oder der Kommunikationstechnologie verwirklicht werden. Typische Beispiele hierfür sind Drucksensoren, elektroakustische Wandler, Mikrophone, Lautsprecher, Schwingungswandler, Lichtdeflektoren, Membrane, Modulatoren für Glasfaseroptik, pyroelektrische Detektoren, Kondensatoren und Kontrollsysteme und "intelligente" Fußböden sowie Systeme zur Umwandlung von mechanischer Energie, insbesondere aus rotierenden oder ggf. auch statistisch oszillierenden Bewegungen, in elektrische Energie.

Unter einem Polyesterpolyol wird ein durch Polykondensation hergestelltes, im Wesentlichen Hydroxylendgruppen aufweisendes Reaktionsprodukt verstanden. Polycarbonatpolyole sind analog aufgebaute Polyester der Kohlensäure. Polyestercarbonatpolyole sind polymere Polyole die Estereinheiten sowohl mit organischen Säuren als auch mit Kohlensäure aufweisen.

Zahlenmittlere Funktionalitäten der isocyanat-reaktiven Verbindung werden rechnerisch dadurch bestimmt, dass man bei einer beliebigen Polyesterpolyolrezeptur zunächst die Anzahl der Moleküle vor Beginn der Reaktion bestimmt. Weiterhin wird die Molzahl an Hydroxylgruppen aller Polyole vor Beginn der Umsetzung ebenso bestimmt, wie die Molzahl an Carboxylgruppen. Bei Verwendung von Carbonsäureanhydriden und/oder Estern aus (zumeist niedermolekularen, monofunktionallen Alkoholen) ergibt sich diese Molzahl an Carboxylgruppen dadurch, dass man Anhydride und/oder Ester gedanklich zu Carbonsäuren hydrolysiert.

Das polymere Additiv besteht dem Umsetzungsprodukt von Polyolen mit einer OH-Zahl $\geq 112$ und $\leq 1400$, und bevorzugt eine OH-Zahl $\geq 200$ und $\leq 900$, mg KOH/g aufweisen mit Monoiso- oder thioisocyanaten.

Vorteilhaft ist, wenn das Polyol eine zahlenmittlere Funktionalität an Isocyanat-reaktiven Gruppen von $\geq 1,5$ und $\leq 6$, ganz besonders bevorzugt $\geq 1,5$ und $\leq 4,4$ und ganz besonders bevorzugt $\geq 1,5$ und $\leq 3,4$, besonders bevorzugt $\geq 1,5$ und $\leq 2,8$ aufweist.

Als Verbindung a) eignen sich erfindungsgemäß beispielsweise 1,4-Butylendiisocyanat, 1,6 Hexamethylendiisocyanat (HDI), Isophorondiisocyanat (IPDI), 2,2,4 und/oder 2,4,4-Trimethylhexamethylendiisocyanat, die isomeren Bis-(4,4'-isocyanatocyclohexyl)methane (H12-MDI) oder deren Mischungen beliebigen Isomerengehalts, 1,4-Cyclohexylendiisocyanat, 4-Isocyanatomethyl-l,8-octandiisocyanat (Nonantriisocyanat), 1,4-Phenylendiisocyanat, 2,4- und/oder 2,6-Toluylendiisocyanat (TDI), 1,5-Naphthylendiisocyanat, 2,2'- und/oder 2,4'- und/oder 4,4'-Diphenylmethandiisocyanat (MDI), 1,3- und/oder 1,4-Bis-(2-isocyanato-prop-2-yl)-benzol (TMXDI), 1,3-Bis(isocyanatomethyl)benzol (XDI), Alkyl-2,6-diisocyanatohexanoate (Lysindiisocyanate) mit Alkylgruppen mit 1 bis 8 Kohlenstoffatomen sowie Mischungen davon. Weiterhin sind Modifizierungen wie etwa Allophanat-, Uretdion-, Urethan-, Isocyanurat-, Biuret-, Iminooxadiazindion- oder Oxadiazintrionstruktur enthaltende Verbindungen basierend auf den genannten Diisocyanaten geeignete Bausteine der Komponente a) sowie mehrkernige Verbindungen wie beispielsweise polymeres MDI (pMDI) sowie Kombinationen von allen. Bevorzugt werden Modifizierungen mit einer Funktionalität von 2 bis 6, bevorzugt von 2,0 bis 4,5 und besonders bevorzugt von 2,6 bis 4,2 und besonders bevorzugt von 2,8 bis 4,0 und ganz besonders bevorzugt von 2,8 bis 3,8 eingesetzt.

Besonders bevorzugt werden zur Modifizierung Diisocyanate aus der Reihe HDI, IPDI, $H_{12}$-MDI, TDI und MDI verwendet. Besonders bevorzugt wird HDI eingesetzt. Ganz besonders bevorzugt wird ein Polyisocyanat auf HDI-Basis mit einer Funktionalität von > 2,3 eingesetzt. Besonders bevorzugt werden Biurete, Allophanate, Isocyanurate sowie Iminooxadiazindion- oder Oxadiazintrionstruktur eingesetzt, ganz besonders bevorzugte Biurete. Der bevorzugte NCO Gehalt liegt > 3 Gew.-%, besonders bevorzugt > 10 Gew.-%, besonders bevorzugt > 15 % und ganz besonders bevorzugt > 18 Gew.-%. Der NCO Gehalt ist ≤ 51 Gew.-%, bevorzugt < 40 Gew.-% ganz besonders bevorzugt < 35 Gew.-%, ganz besonders bevorzugt < 30 Gew.-% und ganz besonders bevorzugt < 25 Gew.-%. Besonders bevorzugt liegt der NCO Gehalt zwischen 18 und 25 Gew.-%. Ganz besonders bevorzugt werden als a) modifizierte aliphatische Isocyanate auf HDI Basis mit einem freien, unreagierten monomeren Anteil an freiem Isocyanat von < 0.5 Gew.-% verwendet.

Es können die Isocyanatgruppen auch partiell oder ganz bis zu ihrer Reaktion mit der Isocyanat-reaktiven Gruppen blockiert vorliegen, so dass sie nicht unmittelbar mit der

Isocyanat-reaktiven Gruppe reagieren können. Dies gewährleistet, dass die Reaktion erst bei einer bestimmten Temperatur (Blockierungstemperatur) stattfindet. Typische Blockierungsmittel finden sich im Stand der Technik und sind so ausgewählt, dass sie bei Temperaturen zwischen 60 und 220 °C, je nach Substanz, von der Isocyanat-Gruppe wieder abspalten und erst dann mit der Isocyanat-reaktiven Gruppe reagieren. Es gibt Blockierungsmittel, die in das Polyurethan eingebaut werden und auch solche, die als Lösemittel bzw. Weichmacher im Polyurethan bleiben oder aus dem Polyurethan ausgasen. Man spricht auch von blockierten NCO-Werten. Ist in der Erfindung von NCO-Werten die Rede, so ist dies immer auf den unblockierten NCO-Wert bezogen. Meist wird bis zu < 0,5% blockiert. Typische Blockierungsmittel sind beispielsweise Caprolactam, Methylethylketoxim, Pyrazole wie beispielsweise 3,5-Dimethyl-1,2-pyrazol oder 1,-Pyrazol, Triazole wie beispielsweise 1,2,4-Triazol, Diisopropylamin, Diethylmalonat, Diethylamin, Phenol oder dessen Derivate oder Imidazol.

Die Isocyanat-Gruppen enthaltenden Verbindung a) kann auch als Mischung von obigen Komponenten verwendet werden. Neben dem One-Shot-Verfahren bei der Umsetzung von a) mit b) kann auch das Prepolymer Verfahren verwendet werden. Hierbei wird ein Teil a) vorher mit b) umgesetzt und erst später mit einer weiteren Komponente b) weiter umgesetzt. Hierbei kann das so hergestellte Prepolymer direkt weiter verarbeitet werden oder erst abgefüllt und gelagert werden und später als Komponente a) eingesetzt werden.

Die Isocyanat-reaktiven Gruppen der Verbindung b) sind funktionelle Gruppen, die unter Ausbildung kovalenter Bindungen mit Isocyanat-Gruppen reagieren können. Insbesondere kann es sich hierbei um Amin-, Epoxy-, Hydroxyl-, Thiol-, Mercapto-, Acryl-, Anhydrid-, Vinyl-, und/oder Carbinol-Gruppen handeln. Besonders bevorzugt handelt es sich bei den Isocyanat reaktive Gruppen um Hydroxyl- und / oder Amin-Gruppen.

Die Verbindung b) kann bevorzugt eine OH-Zahl ≥10 und ≤150, und bevorzugt eine OH-Zahl ≥27 und ≤150, besonders bevorzugt ≥ 27 und ≤ 120 mg KOH/g aufweisen.

Vorteilhaft ist, wenn die Verbindung b) eine zahlenmittlere Funktionalität an Isocyanat-reaktiven Gruppen von ≥ 1,5 und ≤ 6, ganz besonders bevorzugt ≥ 1,5 und ≤ 4,4 und ganz besonders bevorzugt ≥ 1,5 und ≤ 3,4, besonders bevorzugt ≥ 1,5 und ≤ 2,8 aufweist, wobei die Isocyanat-reaktiven Gruppen bevorzugt Hydroxy und / oder Amin sind.

Bevorzugt ist weiterhin, wenn es sich bei der Isocyanat-reaktiven Gruppe der Verbindung b) um ein Polymer handelt.

Gemäß einer vorteilhaften Ausführungsform des erfindungsgemäßen Verfahrens ist vorgesehen, dass die Verbindung b) ein Diol und besonders bevorzugt ein Polyesterpolyol und / oder ein Polycarbonatpolyol umfasst oder daraus besteht. Verbindung b) kann weniger bevorzugt auch ein Polyetherpolyole, Polyetheramine, Polyetheresterpolyole, Polyethercarbonatpolyole, Polybutadienderivate, Polysiloxane sowie deren Mischungen eingesetzt werden, wobei der Anteil an Polyesterbausteinen bevorzugt mindestens 80 Gew.-% beträgt. Bevorzugt umfasst b) jedoch ein Polyol mit mindestens zwei Isocyanat-reaktiven Hydroxylgruppen oder besteht daraus. Geeignete Polyesterpolyole können Polykondensate aus Di- sowie gegebenenfalls Tri- und Tetraolen und Di- sowie gegebenenfalls Tri- und Tetracarbonsäuren oder Hydroxycarbonsäuren oder Lactonen sein. Anstelle der freien Polycarbonsäuren können auch die entsprechenden Polycarbonsäureanhydride oder entsprechende Polycarbonsäureester von niederen Alkoholen zur Herstellung der Polyester verwendet werden.

Polyesterpolyole werden in an sich bekannter Weise durch Polykondensation aus aliphatischen und / oder aromatischen Polycarbonsäuren mit 4 bis 50 Kohlenstoffatomen, gegebenenfalls aus deren Anhydriden sowie gegebenenfalls aus deren niedermolekularen Estern, inklusive Ringestern hergestellt, wobei als Umsetzungskomponente überwiegend niedermolekulare Polyole mit 2 bis 50 Kohlenstoffatomen zum Einsatz kommen. Beispiele für geeignete Alkohole sind dabei Ethylenglykol, Butylenglykol, Diethylenglykol, Triethylenglykol, Polyalkylenglykole wie Polyethylenglykol, weiterhin 1,2-Propandiol, 1,3-Propandiol, Butandiol(1,3), Butandiol(1,4), Hexandiol(1,6) und Isomere, Neopentylglykol oder Hydroxypivalinsäureneopentylglykolester oder Mischungen davon, wobei Hexandiol(1,6), sowie die C7-C20 Diole, und Isomere, Butandiol(1,4), Neopentylglykol und Hydroxypivalinsäureneopentylglykolester bevorzugt sind. Daneben können auch Polyole wie Trimethylolpropan, Glycerin, Erythrit, Pentaerythrit, Trimethylolbenzol oder Trishydroxyethylisocyanurat oder Mischungen davon eingesetzt werden. Besonders bevorzugt werden Diole eingesetzt, ganz besonders bevorzugt Butandiol(1,4) und Hexandiol(1,6), ganz besonders bevorzugt Hexandiol(1,6).

Als Dicarbonsäuren können dabei beispielsweise Phthalsäure, Isophthalsäure, Terephthalsäure, Tetrahydrophthalsäure, Hexahydrophthalsäure, Cyclohexandicarbonsäure, Adipinsäure, Azelainsäure, Sebacinsäure, Glutarsäure, Tetrachlorphthalsäure, Maleinsäure, Fumarsäure, Itaconsäure, Malonsäure, Korksäure, 2-Methylbernsteinsäure, 3,3-Diethylglutarsäure, Fettsäure sowie Dimerfettsäuren und/oder 2,2-Dirnethylbernsteinsäure eingesetzt werden. Als Säurequelle können auch die entsprechenden Anhydride verwendet werden.

Es können zusätzlich auch Monocarbonsäuren, wie Benzoesäure und Hexancarbonsäure Ölsäure, Rizinusöle, mit verwendet werden.

Bevorzugte Säuren sind aliphatische oder aromatische Säuren der vorstehend genannten Art. Besonders bevorzugt sind dabei aliphatische Säuren, besonders bevorzugt mit mehr als 10 Kohlenstoffatomen.

Hydroxycarbonsäuren, die als Reaktionsteilnehmer bei der Herstellung eines Polyesterpolyols mit endständigen Hydroxylgruppen mitverwendet werden können, sind beispielsweise Hydroxycapronsäure, Hydroxybuttersäure, Hydroxydecansäure oder Hydroxystearinsäure oder Mischungen davon. Geeignete Lactone sind Caprolacton, Butyrolacton oder Homologe oder Mischungen davon. Bevorzugt ist dabei Caprolacton.

Als Isocyanat-reaktive Gruppen enthaltende Verbindung b) können Hydroxylgruppen aufweisende Polycarbonate, beispielsweise Polycarbonatpolyole, bevorzugt Polycarbonatdiole, eingesetzt werden. Diese können durch Reaktion von Kohlensäurederivaten, wie Diphenylcarbonat, Dimethylcarbonat oder Phosgen mittels Polykondensation mit Polyolen, bevorzugt Diolen, erhalten werden.

Beispiele hierfür geeigneter Diole sind Ethylenglykol, 1,2- und 1,3-Propandiol, 1,3- und 1,4-Butandiol, 1,6-Hexandiol, 1,8-Octandiol, Neopentylglykol, 1,4-Bishydroxymethylcyclohexan, 2-Methyl-1,3-propandiol, 2,2,4-Trimethylpentandiol-1,3, Dipropylenglykol, Polypropylenglykole, Dibutylenglykol, Polybutylenglykole, Bisphenol A, 1,10-Decandiol, 1,12-Dodecandiol oder lactonmodifizierte Diole der vorstehend genannten Art oder Mischungen davon.

Bevorzugt enthält die Diolkomponente dabei von 40 Gewichtsprozent bis 100 Gewichtsprozent Hexandiol, vorzugsweise 1,6-Hexandiol und/oder Hexandiolderivate. Solche Hexandiolderivate basieren auf Hexandiol und können neben endständigen OH-Gruppen Ester- oder Ethergruppen aufweisen. Derartige Derivate sind beispielsweise durch Reaktion von Hexandiol mit überschüssigem Caprolacton oder durch Veretherung von Hexandiol mit sich selbst zum Di- oder Trihexylenglykol erhältlich. Die Menge dieser und anderer Komponenten, werden im Rahmen der vorliegenden Erfindung in bekannter Weise derart gewählt, dass die Summe 100 Gewichtsprozent nicht überschreitet, insbesondere 100 Gewichtsprozent ergibt. Bevorzugt enthält das Polyesterpolyol eine Säure bzw. ein Anhydrid mit > 20 Kohlenstoffatomen bevorzugt zu > 40 Gew.-%.

Hydroxylgruppen aufweisende Polycarbonate, insbesondere Polycarbonatpolyole, sind bevorzugt linear gebaut. Besonders bevorzugt wird ein Polycarbonatdiol auf Basis von 1,6-Hexandiol verwendet.

Ebenfalls können b) Polyetherpolyole eingesetzt werden, wobei jedoch der Einsatz von Polyesterpolyolen bevorzugt ist. Beispielsweise eignen sich Polytetramethylenglykolpolyether wie sie durch Polymerisation von Tetrahydrofuran mittels kationischer Ringöffnung erhältlich sind. Ebenfalls geeignete Polyetherpolyole können die Additionsprodukte von Styroloxid, Ethylenoxid, Propylenoxid, Butylenoxid und/oder Epichlorhydrin an di- oder polyfunktionelle Startermoleküle sein. Als geeignete Startermoleküle können beispielsweise Wasser, Butyldiglykol, Glycerin, Diethylenglykol, Trimethyolpropan, Propylenglykol, Sorbit, Ethylendiamin, Triethanolamin, oder 1,4-Butandiol oder Mischungen davon eingesetzt werden. Ein geeignetes Polyetherpolyol ist auch 3-Methyl-1,5-Pentandiol und eine davon ausgehende Polymervariante mit höherem Molgewicht.

Auch hydroxyfunktionelles Oligobutadien, hydriertes hydroxyfunktionelles Oligobutadien, hydroxyfunktionelle Siloxane, Glycerin oder TMP-monoallylether können allein oder in beliebiger Mischung eingesetzt werden.

Des Weiteren können Polyetherpolyole mittels alkalischer Katalyse oder mittels Doppelmetallcyanidkatalyse oder gegebenenfalls bei stufenweiser Reaktionsführung mittels alkalischer Katalyse und Doppelmetallcyanidkatalyse aus einem Startermolekül und Epoxiden, bevorzugt Ethylen- und/oder Propylenoxid hergestellt und weisen endständige Hydroxylgruppen auf. Eine Beschreibung von Doppelmetallcyanid-Katalysatoren (DMC-Katalyse) findet sich zum Beispiel in der Patentschrift US 5,158,922 und der Offenlegungsschrift EP 0 654 302 A1.

Als Starter kommen hierbei die dem Fachmann bekannten Verbindungen mit Hydroxyl- und/oder Aminogruppen, sowie Wasser in Betracht. Die Funktionalität der Starter beträgt hierbei mindestens 2 und höchstens 6. Selbstverständlich können auch Gemische von mehreren Startern verwendet werden. Des Weiteren sind als Polyetherpolyole auch Gemische von mehreren Polyetherpolyolen einsetzbar.

Geeignete Verbindungen b) sind auch Esterdiole wie α-Hydroxybutyl-ε-hydroxycapronsäureester, ω-Hydroxyhexyl-γ-hydroxybuttersäure-ester, Adipinsäure-(β-hydroxyethyl)ester oder Terephthalsäurebis(β-hydroxyethyl)-ester.

Ferner können auch monofunktionelle Verbindungen mit eingesetzt werden. Beispiele solcher monofunktionellen Verbindungen sind Ethanol, n-Butanol, Ethylenglykolmonobutylether, Diethylenglykolmonomethylether, Diethylenglykolmonobutylether, Propylenglykolmonomethylether, Dipropylenglykol-monomethylether, Tripropylenglykolmonomethylether, Dipropylenglykolmono-propylether, Propylenglykolmonobutylether, Dipropylenglykolmonobutylether, Tripropylenglykolmonobutylether, 2-Ethylhexanol, 1-Octanol, 1-Dodecanol oder 1-Hexadecanol oder Mischungen davon.

Weniger bevorzugt können zusätzlich Kettenverlängerer bzw. Vernetzungsmittel der Verbindung b) anteilig zugesetzt werden. Hierbei werden bevorzugt Verbindungen mit einer Funktionalität von 2 bis 3 und einem Molekulargewicht von 62 bis 500 verwendet. Es können aromatische oder aliphatische aminische Kettenverlängerer wie zum Beispiel Diethyltoluoldiamin (DETDA), 3,3'-Dichloro-4,4'-diamino-diphenylmethan (MBOCA), 3,5-Di-amino-4-chloro-isobutylbenzoat, 4-Methyl-2,6-bis(methylthio)-1,3-diaminobenzol (Ethacure 300), Trimethylenglykol-di-p-aminobenzoat (Polacure 740M) und 4,4'-Diamino-2,2'-dichloro-5,5'-diethyldiphenylmethan (MCDEA) verwendet werden. Besonders bevorzugt sind MBOCA und 3,5-Diamino-4-chloro-isobutylbenzoat. Erfindungsgemäß geeignete Komponenten zur Kettenverlängerung sind organische Di- oder Polyamine. Beispielsweise können Ethylendiamin, 1,2- Diaminopropan, 1,3-Diaminopropan, 1,4-Diaminobutan, 1,6-Diaminohexan, Isophorondiamin, Isomerengemisch von 2,2,4- und 2,4,4-Trimethylhexamethylendiamin, 2-Methylpentamethylendiamin, Diethylentriamin, Diaminodicyclohexylmethan oder Dimethylethylendiamin oder Mischungen davon eingesetzt werden.

Darüber hinaus können auch Verbindungen, die neben einer primären Aminogruppe auch sekundäre Aminogruppen oder neben einer Aminogruppe (primär oder sekundär) auch OH-Gruppen aufweisen, eingesetzt werden. Beispiele hierfür sind primäre/sekundäre Amine, wie Diethanolamin, 3-Amino-1-methylaminopropan, 3-Amino-1-ethylaminopropan, 3-Amino-1-cyclohexylaminopropan, 3-Amino-1-methylaminobutan, Alkanolamine wie N-Aminoethylethanolamin, Ethanolamin, 3-Aminopropanol, Neopentanolamin. Zur Kettenterminierung werden üblicherweise Amine mit einer gegenüber Isocyanaten reaktiven Gruppe wie Methylamin, Ethylamin, Propylamin, Butylamin, Octylamin, Laurylamin, Stearylamin, Isononyloxypropylamin, Dimethylamin, Diethylamin, Dipropylamin, Dibutylamin, N-Methylaminopropylamin, Diethyl(methyl)aminopropylamin, Morpholin, Piperidin, beziehungsweise geeignete substituierte Derivate davon, Amidamine aus diprimären Aminen und Monocarbonsäuren, Monoketim von diprimären Ammen, primär/tertiäre Amine, wie N,N-Dimethylaminopropylamin, verwendet.

Oftmals haben diese einen thixotropen Effekt auf Grund ihrer hohen Reaktivität, so dass die Rheologie so verändert wird, dass das Gemisch auf dem Substrat eine höhere Viskosität hat. Als nicht aminische Kettenverlängerer werden oftmals beispielsweise 2,2'-Thiodiethanol, Propandiol-1,2, Propandiol-1,3, Glycerin, Butandiol-2,3, Butandiol-1,3, Butandiol-1,4, 2-Methylpropandiol-1,3, Pentandiol-1,2, Pentandiol-1,3, Pentandiol-1,4, Pentandiol-1,5, 2,2-Dimethyl-propandiol-1,3, 2-Methylbutandiol-1,4, 2-Methylbutandiol-1,3, 1,1,1-Trimethylolethan, 3-Methyl-1,5-Pentandiol, 1,1,1-Trimethylolpropan, 1,6-Hexandiol, 1,7-Heptandiol, 2-Ethyl-1,6-Hexandiol, 1,8-Octandiol, 1,9-Nonandiol, 1,10-Decandiol 1,11-Undecandiol, 1,12-Dodecandiol, Diethylenglykol, Triethylenglykol, 1,4-Cyclohexandiol, 1,3-Cyclohexandiol und Wasser verwendet.

Die Isocyanat-reaktive Gruppen enthaltenden Verbindung b) kann auch als Mischung von obigen Komponenten verwendet werden

Besonders bevorzugt haben a) und b) niedrige Gehalte an freiem Wasser, Restsäuren und Metallgehalten. Bevorzugt beträgt der Restwassergehalt von b) < 1 Gew.-% besonders bevorzugt < 0.7 Gew.-% (bezogen auf b)). Der Restsäuregehalt von b) ist bevorzugt < 1 Gew.-%, besonders bevorzugt < 0.7 Gew.-% (bezogen auf B). Die Restmetallgehalte, verursacht beispielsweise durch Reste von Katalysatorbestandteilen, die bei der Herstellung der Edukte verwendet werden, sollten bevorzugt kleiner als 1000 ppm sein und weiter bevorzugt kleiner als 500 ppm, bezogen auf die a) bzw. b), sein.

Das Verhältnis von Isocyanat-reaktiven Gruppen zu Isocyanat-Gruppen kann in der Mischung von 1:3 bis 3:1, vorzugsweise von 1:1,5 bis 1,5:1 besonders bevorzugt von 1:1,3 bis 1,3:1 und ganz besonders bevorzugt von 1:1,02 bis 1:0,95 betragen.

Die Reaktionsmischung ("Mischung") kann neben den Verbindungen a) und b) zusätzlich auch Hilfs- und Zusatzstoffe enthalten. Beispiele für solche Hilfs- und Zusatzstoffe sind Vernetzer, Verdicker, Lösungsmittel, Thixotropiermittel, Stabilisatoren, Antioxidantien, Lichtschutzmittel, Emulgatoren, Tenside, Klebstoffe, Weichmacher, Hydrophobierungsmittel, Pigmente, Füllstoffe, Rheologieverbesserer, Weichmacher, Entgasungs- und Entschäumungshilfsmittel, Benetzungsadditive und Katalysatoren sowie Füllstoffe. Besonders bevorzugt enthält die Mischung Benetzungsadditive. Üblicherweise ist das Benetzungsadditiv in einer Menge von 0,05 bis 1,0 Gew.-% in der Mischung enthalten. Typische Benetzungsadditive sind beispielsweise von der Firma Altana erhältlich (Byk Additive wie etwa: polyestermodifiziertes Polydimethylsiloxan, polyethermodifiziertes Polydimethylsiloxan oder Acrylat-Copolymere, sowie beispielsweise $C_6F_{13}$-Fluortelomere).

Als Lösungsmittel können wässrige sowie organische Lösemittel verwendet werden.

Vorzugsweise kann ein Lösungsmittel verwendet werden, dass einen Dampfdruck bei 20 °C von > 0,1 mbar und < 200 mbar, bevorzugt > 0,2 mbar und < 150 mbar und besonders bevorzugt > 0,3 mbar und < 120 mbar aufweist. Hierbei ist besonders vorteilhaft, dass die erfindungsgemäßen Filme auf einer Rollenbeschichtungsanlage hergestellt werden können.

Die "zahlenmittlere Funktionalität" als Merkmal im erfindungsgemäßen Verfahren wird wie folgt veranschaulicht. Die höhere funktionale Verbindung ist hierbei entscheidend, wobei die Differenz der niedriger funktionalen Verbindung minus 2 zur höher funktionalen Verbindung addiert wird. Hat beispielsweise b) eine (durchschnittliche) Funktionalität von 2,1 und a) von 2,6 so gilt: 2,1-2=0,1. Diese Differenz wird 2,6 zugerechnet: 2,6 + 0,1 = 2,7. So ist die zahlenmittlere Funktionalität 2,7. Alternativ: wenn b) 2,7 und a) 2,3 ist, so gilt zahlenmittlere Funktionalität = 2,7 + 2,3-2 = 3,0.

Weitere Aspekte und Ausführungsformen der vorliegenden Erfindung werden nachfolgend beschrieben. Sie können beliebig miteinander kombiniert werden, sofern sich aus dem Kontext nicht einwandfrei das Gegenteil ergibt.

In einer weiteren Ausführungsform des erfindungsgemäßen Verfahrens umfasst die Isocyanat-Gruppen enthaltende Verbindung a) ein Biuret und/oder Isocyanurat von Hexamethylendiisocyanat.

In einer ganz besonders bevorzugten Ausführungsform wird der Polymerfilm gemäß WO 2014/001272 im Rolle zu Rolle Verfahren unter Zugabe von organischen Lösemitteln und einem Benetzungsadditiv hergestellt. Die Reaktionsmischung wird hierbei beispielsweise mit einer Nassfilmdicke von 10 bis 300 $\mu$m, bevorzugt von 15 bis 150 $\mu$m, weiter bevorzugt von 20 bis 120 $\mu$m und ganz besonders bevorzug von 20 bis 80 $\mu$m aufgetragen.

Darüber hinaus ist auch ein elektromechanischer Wandler, umfassend eine erfindungsgemäße Polyurethan-Schichtanordnung Gegenstand der Erfindung. Bei dem elektromechanischen Wandler ist die Elektrodenschicht auf den Lagen des Dielektrikums vorzugsweise so aufgebracht, dass sie von den Seiten kontaktiert werden kann und nicht über dem dielektrischen Film hinausragt, da es sonst zu Durchschlägen kommt. Üblicherweise lässt man hier zwischen Elektrode und Dielektrikum einen Sicherheitsrand, so dass die Elektrodenfläche kleiner als das Dielektrikum ist. Die Elektrode ist so strukturiert, dass eine Leiterbahn zur elektrischen Kontaktierung herausgeführt wird.

Der Wandler kann vorteilhaft in unterschiedlichsten Konfigurationen zur Herstellung von Sensoren, Aktoren und/oder Generatoren eingesetzt werden.

Ein weiterer Gegenstand der vorliegenden Erfindung ist eine elektronische und/oder elektrische Vorrichtung, insbesondere ein Baustein, Automat, Instrument oder eine Komponente, umfassend einen erfindungsgemäßen elektromechanischen Wandler.

Ferner betrifft die vorliegende Erfindung die Verwendung eines erfindungsgemäßen elektromechanischen Wandlers in einer elektronischen und/oder elektrischen Vorrichtung, insbesondere in einem Aktor, Sensor oder Generator. Vorteilhafterweise kann die Erfindung in einer Vielzahl von verschiedensten Anwendungen im elektromechanischen und elektroakustischen Bereich, insbesondere im Bereich der Energiegewinnung aus mechanischen Schwingungen (Energy-Harvesting), der Akustik, des Ultraschalls, der medizinischen Diagnostik, der akustischen Mikroskopie, der mechanischen Sensorik, insbesondere Druck- Kraft- und/oder Dehnungssensorik, der Robotik und/oder der Kommunikationstechnologie (Optik, Justage von Linsen, Gitter, o. ä.) verwirklicht werden. Typische Beispiele hierfür sind Drucksensoren, elektroakustische Wandler, Mikrophone, Lautsprecher, Schwingungswandler, Lichtdeflektoren, Membrane, Modulatoren für Glasfaseroptik, pyroelektrische Detektoren, Kondensatoren und Kontrollsysteme und "intelligente" Fußböden sowie Systeme zur Umwandlung von mechanischer Energie, insbesondere aus rotierenden oder oszillierenden Bewegungen, in elektrische Energie.

Die Erfindung wird im Folgenden anhand der nachfolgenden Beispiele näher erläutert.

Beispiele:

Sofern nicht abweichend gekennzeichnet, beziehen sich alle Prozentangaben auf das Gewicht.

Sofern nicht abweichend vermerkt, würden alle analytischen Messungen bei Temperaturen von 23 °C unter Normalbedingungen durchgeführt.

Methoden:

NCO-Gehalte wurden, wenn nicht ausdrücklich anders erwähnt, volumetrisch gemäß DIN EN ISO 11909 bestimmt.

Hydroxylzahlen (OHZ in mgKOH/g Substanz) wurden gemäß DIN 53240 (Dezember 1971) bestimmt.

Messungen der Filmschichtdicken wurden mit einem mechanischen Taster der Firma Dr. Johannes Heidenhain GmbH, Deutschland, Dr.-Johannes-Heidenhain-Str. 5, 83301 Traunreut, durchgeführt. Die Probekörper wurden an drei unterschiedlichen Stellen vermessen und der Mittelwert als repräsentativer Messwert benutzt.

Die Zugversuche wurden mittels einer Zugmaschine der Firma Zwick, Modell Nummer 1455, ausgestattet mit einer Kraftmessdose des Gesamtmessbereiches 1kN nach DIN 53 504 mit einer Zuggeschwindigkeit von 50 mm/min ausgeführt. Als Probekörper wurden S2-Zugstäbe eingesetzt. Jede Messung wurde an drei gleichartig präparierten Probekörpern ausgeführt und der Mittelwert der erhaltenen Daten zur Bewertung verwendet. Speziell hierfür wurden neben der Zugfestigkeit in [MPa] und der Bruchdehnung in [%] noch die Spannung in [MPa] bei 100% und 200% Dehnung bestimmt.

Die Bestimmung der Spannungsrelaxation ("Creep") gemäß DIN 53 441 wurde auf der Zugmaschine Zwicki ausgeführt; die Instrumentierung entspricht dabei dem Versuch zur Bestimmung der bleibenden Dehnung. Als Probekörper wurde hierbei eine streifenförmige Probe der Dimension 60 x 10 mm$^2$ eingesetzt, die mit einem Klemmenabstand von 50 mm eingespannt wurde. Nach einer schlagartigen Deformation auf 55 mm wurde diese Deformation für die Dauer von 30 min konstant gehalten und während dieser Zeit der Kraftverlauf bestimmt. Die Spannungsrelaxation nach 30 min ist der prozentuale Abfall der Spannung, bezogen auf den Anfangswert direkt nach der Deformation auf 55 mm.

Die Messungen der Dielektrizitätskonstante gemäß ASTM D 150-98 wurden mit einem Messaufbau der Firma Novocontrol Technologies GmbH & Co. KG, Obererbacher Straße 9, 56414 Hundsangen, Deutschland (Messbrücke : Alpha-A Analyzer, Messkopf: ZGS Active Sample Cell Test Interface) mit einem Durchmesser der Probekörper von 20 mm ausgeführt. Untersucht wurde dabei ein Frequenzbereich von $10^7$ Hz bis $10^{-2}$ Hz. Als Maß für die Dielektrizitätskonstante des untersuchten Materials wurde der Realteil der Dielektrizitätskonstante bei 10-0,01 Hz gewählt.

Die Bestimmung des elektrischen Wiederstandes geschah mittels eines Laboraufbaus der Fa. Keithley Instruments (Keithley Instruments GmbH, Landsberger Straße 65, D-82110 Germering Germany) Modell Nr.: 6517 A und 8009 gemäß ASTM D 257, einer Methode zur Bestimmung des Isolationswiderstandes von Werkstoffen.

Die Bestimmung der Durchbruchsfeldstärke gemäß ASTM D 149-97a wurde mit einer Hochspannungsquelle Modell hypotMAX der Firma Associated Research Inc, 13860 W Laurel Drive, Lake Forest, IL 600045-4546, USA und einem eigenkonstruierten Probenhalter durchgeführt. Der Probenhalter kontaktiert die homogen dicken Polymerproben mit nur geringer mechanische Vorbelastung und verhindert, dass der Bediener in Kontakt mit der Spannung kommt. Die nicht vorgespannte Polymerfolie wird in diesem Aufbau mit steigender Spannung statisch belastet, bis ein elektrischer Durchbruch durch die Folie erfolgt. Messergebnis ist die beim Durchbruch erreichte Spannung, bezogen auf die Dicke der Polymerfolie in [V/$\mu$m]. Es werden je Folie 5 Messungen ausgeführt und der Mittelwert angegeben.

Die Knotendichte der Elastomere wurde wie vorstehend erläutert bestimmt (siehe auch EP 1 556 429 B1)

**Verwendete Substanzen und Abkürzungen:**

| | |
|---|---|
| Desmodur® N100 | Biuret auf Basis von Hexamethylendiisocyanat, NCO-Gehalt 220 $\pm$ 0,3 % (nach DIN EN ISO 11 909), Viskosität bei 23 °C 10000 $\pm$ 2000 mPa·s, Bayer MaterialScience AG, Leverkusen, DE |
| P200H/DS | Polyesterpolyol auf Basis von 44,84 Gew.-% 1,6-Hexandiol und 55,16 Gew.-% Phthalsäureanhydrid, Molgewicht 2000 g/mol, Bayer MaterialScience AG, Leverkusen, DE |
| DBTDL | Dibutyl-Zinn-Dilaurat der Firma E-Merck KGaA, Frankfurter Str. 250, D-64293 Darmstadt, Germany |
| Desmophen 250 | Polyetherpolyol der Fa. Bayer MaterialScience AG, 868 mgKOH/g, Funktionalität 3 |
| Desmophen 49WB80 | Polyetherpolyol der Fa. Bayer MaterialScience AG, 415 mgKOH/g, Funktionalität 2 |
| para-Trifluormethoxyphenylisocyanat | Sigma-Aldrich |
| 3,4-Dichlorphenylisocyanat | Sigma-Aldrich |
| Para-Nitrophenylisocyanat | Sigma-Aldrich |
| Hostaphan RN 2SLK: | Trennfolie der Firma Mitsubishi auf Basis Polyethylenterephthalat mit Silikonbeschichtung. Es wurde eine 300 mm breite Folie verwendet. |

### Herstellung der Filme

Alle Filme wurden mit dem Isocyanat N100 in gleicher Weise hergestellt; Unterschiede ergaben sich nur in der Herstellung der Laborfilme und der Filme im Rolle-zu-Rolle-Prozess. Nachfolgend werden die beiden Herstellungsarten exemplarisch beschrieben.

### Herstellung der Additive:

Das jeweilige Monoisocyanat wurde stöchiometrisch mit dem jeweiligen Polyol umgesetzt. Es wurde in Substanz für 2 h gerührt, bis keine freien NCO Gruppen mehr bestimmt wurden.

### Herstellung eines Films im Labor:

Es wurden 21,39 Gew.-Teile Desmodur N100, mit einer Polyolmischung aus 0,01 Gew.-Teilen DBTL sowie 100 Gew.-Teilen P200H/DS und der entsprechenden Menge Additiv gemäß Tabelle 1 mit einander umgesetzt. Das Isocyanat (Desmodur N100) wurde bei 40 °C eingesetzt, die Polyolabmischung (Polyesterpolyol mit TIB Kat 220) bei 80 °C. Das Verhältnis von NCO zu OH Gruppen lag bei 1,07. Es wurde auf die Hostaphan Folie gegossen und 1 h bei 100°C im Heizschrank getrocknet.

### Bewertung der Beispiele und Versleichsbeispiele:

Tabelle 1 enthält alle Ergebnisse. Das unkontrolliert einpolymerisierte, reaktive Additiv aus dem Vergleichsbeispiel erhöht den Creep auf 15% sowie den Modul um 20%. Auch zeigten sich hier Entmischungen, die auf die unkontrollierte Reaktion des Additivs während der Filmbildung zurückzuführen sind. Dasselbe Verhalten wurde bei der Verwendung der Isocyanate ohne Ankupplung an das Polyol beobachtet (beispielsweise bei Verwendung von Trifluormethoxy-phenyl-isocyanat als reaktive Komponente). Die Verbindungen zeigten alle eine erhöhte Reaktivität bei der Filmherstellung.

Alle anderen polymeren Additive erhöhen die Dielektrizitätskonstante ohne die anderen Eigenschaften des polymeren Systems negativ zu beeinflussen. Die Dielektrizitätskonstante wird von 6,19 auf bis zu 9,67 (56% Verbesserung) erhöht. Aufgrund der polymeren Struktur des Additivs konnten Migrationen auch nach 6 Monaten nicht beobachtet werden. Da die polymere Struktur Polyurethan-basiert ist, konnten auch keine Entmischungen des Additivs im System infolge mangelnder Verträglichkeit beobachtet werden. Auch wurde kein negativer Einfluss auf die Reaktivität des Systems bei Zugabe der polymeren Weichmacher beobachtet.

| Beispiel | Additiv | Gew.-% Additiv im Film | Dehnung max. [%] | Spannung 025% [N/mm$^2$] | E' (0%) [MPa] | Creep | Epsilon' bei 1Hz | VolumenWiderstand [Ohm cm] | Durchbruchfeldstärke [V/μm] |
|---|---|---|---|---|---|---|---|---|---|
| 1 | Trifluormethoxyphenyl-isocyanat + Desmophen 250 | 10 | 225,2 | 0,607 | 2,97 | 6,31 | 8,94 | 1,309E+13 | 90,71 |
| 2 | Dichlorphenylisocyanat + Desmophen 250 | 10 | 307,1 | 0,623 | 3,35 | 8,91 | 8,53 | 1,139E+13 | 95,08 |
| 3 | Nitrophenylth iocyanat + 49WB80 | 10 | 266,2 | 0,562 | 2,62 | 5,34 | 8,85 | 1,667E+13 | 89,66 |
| 4 | Nitrophenylth iocyanat + Desmophen 250 | 10 | 127,0 | 0,640 | 2,93 | 1,11 | 7,92 | 1,048E+14 | 95,32 |
| 5 (Vergleich) | N,N-Bis-(2-Hydroxyethyl)-4-Nitroanilin | 10 | 231,4 | 0,851 | 4,75 | 15,21 | 9,33 | 2,449E+14 | 94,37 |
| Referenz | | 0 | 285,9 | 0,709 | 3,66 | 3,53 | 6,19 | 1,795E+14 | 98,57 |
| 6 | Trifluormethoxy-phenyl-isocyanat + 49WB80 | 10 | 178,4 | 0,620 | 2,96 | 1,27 | 9,67 | 1,28E+13 | 86,63 |
| 7 | Trifluormethoxy-phenyl-isocyanat + Desmophen 250 | 10 | 194,0 | 0,647 | 3,12 | 4,18 | 9,04 | 2,089E+13 | 96,96 |

Das Beispiel "Referenz" ist ohne jegliches Additiv hergestellt. Beispiel 5 ist eine Formulierung, bei dem ein nicht erfindungsgemäßes Additiv eingesetzt wurde. Die erfindungsgemäßen Additive senken den Modul und erhöhen die Dielektrizitätskonstante ohne die Durchbruchfeldstärke sowie den Widerstand oder Creep negativ zu beeinflussen.

**Patentansprüche**

1. Verfahren zur Herstellung eines dielektrischen Polyurethan-Polymers durch Umsetzung einer Mischung umfassend:

   a) eine Isocyanat-Gruppen enthaltenden Verbindung mit einer zahlenmittleren Isocyanat-Funktionalität von > 2,3 und $\leq$ 6;
   b) eine Isocyanat-reaktive Gruppen enthaltenden Verbindung mit einer zahlenmittleren Funktionalität an Isocyanat-reaktiven Gruppen von $\geq$ 1,5 und $\leq$ 6;
   c) einem polymeren Additiv erhältlich durch stöchiometrische Umsetzung

   c1) eines Monoisocyanats der allgemeinen Formel Ia und / oder Ib NCO-X-(A)n (Formel Ia) NCS-X-(A)n (Formel Ib)
   mit
   c2) einer Polyolkomponente mit einem zahlenmittlerem Molgewicht Mn von 100 bis 1500 g/mol und einer Funktionalität von 2 bis 4;

   d) optional einen Katalysator;
   wobei
   X ein organischer Rest mit einem delokalisierten Elektronensystem,
   A eine Elektronenakzeptorfunktionalität, ausgewählt aus der Gruppe bestehend aus $-NO_2$, -CN, -F, -Cl, $-CF_3$, $-OCF_3$, Cyanovinyl-, Dicyanovinyl- oder Tricyanovinyl-Resten und
   n eine Ganze Zahl von 1 bis 3 ist.

2. Verfahren nach Anspruch 1, **dadurch gekennzeichnet, dass** das polymere Additiv c) in einer Menge von 2 Gew.-% bis 50 Gew.-% bezogen die gesamte Mischung zur Herstellung eines dielektrischen Polyurethans eingesetzt wird.

3. Verfahren nach Anspruch 1 oder 2, **dadurch gekennzeichnet, dass** die Polyolkomponente c2) ausgewählt ist aus der Gruppe bestehend aus Polyesterpolyolen, Polycarbonatpolyolen und Polyestercarbonatpolyolen.

4. Verfahren nach einem der vorstehenden Ansprüche, **dadurch gekennzeichnet, dass** die Polyolkomponente c2) eine OH-Zahl $\geq$ 112 und $\leq$ 1400 mg KOH/g aufweist, insbesondere > 200 und $\leq$ 900.

5. Verfahren nach einem der vorstehenden Ansprüche, **dadurch gekennzeichnet, dass** polymeren Additiv c) erhältlich ist durch stöchiometrische Umsetzung von c1), c2) und zumindest einer monofunktionellen Verbindungen c3), wobei die monofunktionelle Verbindung c3) insbesondere ausgewählt ist aus Ethanol, n-Butanol, Ethylenglykolmonobutylether, Diethylenglykolmonomethylether, Diethylenglykolmonobutylether, Propylenglykolmonomethylether, Dipropylenglykol-monomethylether, Tripropylenglykolmonomethylether, Dipropylenglykolmono-propylether, Propylenglykolmonobutylether, Dipropylenglykolmonobutylether, Tripropylenglykolmonobutylether, 2-Ethylhexanol, 1-Octanol, 1-Dodecanol oder 1-Hexadecanol oder Mischungen davon.

6. Verfahren nach einem der vorstehenden Ansprüche, **dadurch gekennzeichnet, dass** es sich bei den Isocyanat-reaktiven Gruppen der Verbindung b) um Hydroxyl- und / oder Amin-Gruppen handelt, wobei die Isocyanat-reaktive Gruppen enthaltende Verbindung b) insbesondere eine OH-Zahl von $\geq$ 10 und $\leq$ 150 mg KOH/g besitzt, bevorzugt von $\geq$ 27 und $\leq$ 150, besonders bevorzugt $\geq$ 27 und $\leq$ 120.

7. Verfahren nach einem der vorstehenden Ansprüche, **dadurch gekennzeichnet, dass** die Isocyanat-reaktive Gruppen enthaltende Verbindung b) und / oder die Polyolkomponente c2) eine zahlenmittlere OH-Funktionalität von $\geq$ 1,5 und $\leq$ 6 aufweist, insbesondere $\geq$ 1,5 und $\leq$ 4,4, bevorzugt $\geq$ 1,5 und $\leq$ 3,4, besonders bevorzugt $\geq$ 1,5 und $\leq$ 2,8.

8. Verfahren nach einem der vorstehenden Ansprüche, **dadurch gekennzeichnet, dass** das dielektrische Polyurethan-Polymer erhalten wird, indem

   • die gesamten Einsatzmengen an a) und b) in Anwesenheit von c) sowie gewünschtenfalls d)

oder

• zunächst eine Teilmenge der Isocyanat-Gruppen enthaltenden Verbindung a) mit einer Teilmenge der Isocyanat-reaktive Gruppen enthaltenden Verbindung b) umgesetzt und das dabei erhaltene Präpolymer anschließend mit der der Restmenge der Isocyanat-Gruppen enthaltenden Verbindung a) in Anwesenheit von c) sowie gewünschtenfalls d)
umgesetzt wird.

9. Dielektrisches Polyurethan-Polymer erhältlich oder erhalten nach einem der Ansprüche 1 bis 8.

10. Dielektrisches Polyurethan-Polymer nach Anspruch 9, **dadurch gekennzeichnet, dass** es eine, mehrere oder sämtliche der folgenden Eigenschaften aufweist:

   a. Einen Zugmodul von < 5 MPa bei 25% Dehnung nach DIN 53 504;
   b. eine Bruchdehnung von > 20% nach DIN 53 504, insbesondere > 50%, bevorzugt > 80%;
   c. eine Spannungsrelaxation (Creep) gemäß DIN 53 441 bei 10% Deformation nach 30 min nach DIN 53 441 von < 20%, insbesondere < 15%, bevorzugt < 10%;
   d. eine Durchbruchfeldstärke von > 40 V/$\mu$m nach ASTM D 149-97a, insbesondere > 60 V/$\mu$m, bevorzugt > 80 V/$\mu$m;
   e. einen elektrischen Widerstand von > 1,0 E10 Ohm m nach ASTM D 257, insbesondere > 1,0 E11 Ohm m, bevorzugt > 5,0 E11 Ohm m;
   f. eine Dielektrizitätskonstante von > 8 bei 0,01 - 1 Hz nach ASTM D 150-98;
   g. eine Knotendichte > 0,13 mol/kg und < 1,5 mol /kg;
   h. eine Energiedichte > 0,2 J/cm$^3$;
   i. eine Dielektrizitätskonstante nach ASTM D 150-98 bei 1 Hz von wenigstens 8, insbesondere von 8 bis 15;
   j. eine elektrische Durchschlagfestigkeit von wenigstens 80 V/$\mu$m nach ASTM D 149-97a, insbesondere von 80 bis 230;
   k. einen elektrischen Volumenwiderstand von wenigstens 1 E11 V/cm nach ASTM D 257, insbesondere von 1,0 E11 V/cm bis 8,0 E16 V/cm;
   l. einen Creep gemäß DIN 53 441 von wenigstens 12%, insbesondere von 0.15 bis 12.

11. Verwendung eines dielektrischen Polyurethan-Polymers nach Anspruch 9 oder 10 oder eines Blends aus diesem dielektrischen Polyurethan-Polymer und wenigstens einem weiteren Polymer ausgewählt aus der Gruppe bestehend aus Elastomeren, insbesondere linearen oder vernetzten Polyalkylsiloxanen, linearen oder vernetzten partiell wasserstofffunktionalisierten Polysiloxanen, Polyurethanen, Polybutadienkautschuken und/oder Poly(meth)acrylaten, als Dielektrikum, als elastisches Dielektrikum, als Aktuator, als künstlicher Muskel, als Dielektrikum für flexible elektronische Bauteile, insbesondere Kondensatoren, insbesondere weiche Kondensatoren.

12. Formkörper in Form eines Dielektrikums, eines künstlichen Muskels und/oder eines Aktuators, wie vorgestreckte Aktuatoren und/oder Stapelaktuatoren, wobei der Formkörper ein dielektrisches Polyurethan-Polymer nach Anspruch 9 oder 10 oder ein Blend aus diesem dielektrischen Polyurethan-Polymer und wenigstens einem weiteren Polymer enthält, wobei das weitere Polymer ausgewählt ist aus der Gruppe bestehend aus Elastomeren, insbesondere linearen oder vernetzten Polyalkylsiloxanen, linearen oder vernetzten partiell wasserstofffunktionalisierten Polysiloxanen, Polyurethanen, Polybutadienkautschuken und/oder Poly(meth)acrylaten.

13. Elektrochemischer Wandler, enthaltend ein dielektrisches Polyurethan-Polymer nach Anspruch 9 oder 10 oder oder ein Blend aus diesem dielektrischen Polyurethan-Polymer und wenigstens einem weiteren Polymer enthält, wobei das weitere Polymer ausgewählt ist aus der Gruppe bestehend aus Elastomeren, insbesondere linearen oder vernetzten Polyalkylsiloxanen, linearen oder vernetzten partiell wasserstofffunktionalisierten Polysiloxanen, Polyurethanen, Polybutadienkautschuken und/oder Poly(meth)acrylaten.

Europäisches
Patentamt

European
Patent Office

Office européen
des brevets

**Nummer der Anmeldung**

# EUROPÄISCHER RECHERCHENBERICHT

EP 15 16 9903

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | WO 2008/095621 A1 (BAYER MATERIALSCIENCE AG [DE]; JENNINGER WERNER [DE]; KOEHLER BURKHARD) 14. August 2008 (2008-08-14) <br> * Seite 1, Zeile 3 - Seite 2, Zeile 26 * <br> * Seite 6; Beispiel 2; Tabelle 1 * <br> ----- | 1-13 | INV. <br> C08G18/78 <br> C08G18/42 <br> C08G18/48 <br> C08G18/71 <br> C08G18/28 |
| A,D | WO 2012/038093 A1 (FRAUNHOFER GES FORSCHUNG [DE]; KRUEGER HARTMUT [DE]; KUSSMAUL BJOERN []) 29. März 2012 (2012-03-29) <br> * Seite 1, Zeile 5 - Seite 3, Zeile 18 * <br> * Seite 7, Zeile 1 - Seite 8, Zeile 15 * <br> * Seite 10, Zeile 18 - Seite 12, Zeile 23 * <br> * Seiten 22-25; Tabelle 1 * <br> ----- | 1-13 | C08G18/50 <br> C08J5/18 <br> H01L41/00 |
| A | DATABASE WPI <br> Week 198227 <br> Thomson Scientific, London, GB; <br> AN 1982-56195E <br> XP002742147, <br> & JP S57 87417 A (MITSUBISHI ELECTRIC CORP) 31. Mai 1982 (1982-05-31) <br> * Zusammenfassung * <br> ----- | 1-13 | |

RECHERCHIERTE SACHGEBIETE (IPC)

C08G
C08J
H01L

Der vorliegende Recherchenbericht wurde für alle Patentansprüche erstellt

| Recherchenort | Abschlußdatum der Recherche | Prüfer |
|---|---|---|
| München | 3. November 2015 | Neugebauer, Ute |

KATEGORIE DER GENANNTEN DOKUMENTE

X : von besonderer Bedeutung allein betrachtet
Y : von besonderer Bedeutung in Verbindung mit einer
  anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
  nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
  Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 15 16 9903

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

03-11-2015

| Im Recherchenbericht angeführtes Patentdokument | Datum der Veröffentlichung | Mitglied(er) der Patentfamilie | Datum der Veröffentlichung |
|---|---|---|---|
| WO 2008095621 A1 | 14-08-2008 | AT 537214 T | 15-12-2011 |
| | | BR PI0807162 A2 | 29-04-2014 |
| | | CA 2677393 A1 | 14-08-2008 |
| | | CN 101605845 A | 16-12-2009 |
| | | DE 102007005960 A1 | 14-08-2008 |
| | | DK 2118190 T3 | 26-03-2012 |
| | | EP 2118190 A1 | 18-11-2009 |
| | | ES 2377237 T3 | 23-03-2012 |
| | | JP 2010518200 A | 27-05-2010 |
| | | KR 20090116736 A | 11-11-2009 |
| | | PT 2118190 E | 15-02-2012 |
| | | US 2008188615 A1 | 07-08-2008 |
| | | US 2010022706 A1 | 28-01-2010 |
| | | WO 2008095621 A1 | 14-08-2008 |
| WO 2012038093 A1 | 29-03-2012 | DE 102010046343 A1 | 29-03-2012 |
| | | EP 2619250 A1 | 31-07-2013 |
| | | JP 2013539803 A | 28-10-2013 |
| | | KR 20140043883 A | 11-04-2014 |
| | | US 2013253146 A1 | 26-09-2013 |
| | | WO 2012038093 A1 | 29-03-2012 |
| JP S5787417 A | 31-05-1982 | JP S5787417 A | 31-05-1982 |
| | | JP S6028842 B2 | 06-07-1985 |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0106575 A
- WO 2012038093 A
- WO 2012038093 A1
- EP 1556429 B1
- US 5158922 A
- EP 0654302 A1
- WO 2014001272 A

**In der Beschreibung aufgeführte Nicht-Patentliteratur**

- **BUCH VON FEDERICO CARPI.** Dielectric Elastomers as Electromechanical Transducers. Elsevier, 314
- **R. PELRINE.** *Science,* 2000, vol. 287 (5454), 837
- **CHRISTIAN GRAF ; JÜRGEN MAAS.** Energy harvesting cycles based on electro active polymers. *proceedings of SPIE Smart structures,* 2010, vol. 7642, 764217
- **Q. M. ZHANG ; H. LI ; M. POH ; F. XIA ; Z.-Y. CHENG ; H. XU ; C. HUANG.** An all-organic composite actuator material with a high dielectric constant. *Nature,* 2002, vol. 419, 284-287
- **C. HUANG ; Q. ZHANG.** Fully functionalized high-dielectric-constant nanophase polymers with high electromechanical response. *Adv. Mater,* 2005, vol. 17, 1153